Europäisches Patentamt

European Patent Office

Office européen des brevets

(19)

(11) Publication number: **0 138 517**
**B1**

# EUROPEAN PATENT SPECIFICATION

(45) Date of publication of patent specification: **06.07.88**

(21) Application number: **84306756.2**

(22) Date of filing: **04.10.84**

(60) **Consolidated with 84903741.1/0158670 (European application No./publication No.) by decision dated 27.08.87.**

(51) Int. Cl.⁴: **H 01 L 27/08, H 01 L 21/76**

(54) **Semiconductor integrated circuits containing complementary metal oxide semiconductor devices.**

(30) Priority: **11.10.83 US 540623**
**11.10.83 US 540624**

(43) Date of publication of application:
**24.04.85 Bulletin 85/17**

(45) Publication of the grant of the patent:
**06.07.88 Bulletin 88/27**

(84) Designated Contracting States:
**CH DE FR GB IT LI NL**

(56) References cited:
**EP-A-0 048 175**
**EP-A-0 135 354**

**INTERNATIONAL ELECTRON DEVICES MEETING, San Francisco, 13th-15th December 1982, Technical Digest, pages 237-240, IEEE, New York, USA; R.D. RUNG et al.: "Deep trench isolated CMOS devices"**

The file contains technical information submitted after the application was filed and not included in this specification

(73) Proprietor: **AMERICAN TELEPHONE AND TELEGRAPH COMPANY**
**550 Madison Avenue**
**New York, NY 10022 (US)**

(72) Inventor: **Coquin, Gerald Allan**
**22 Foley Place**
**New Providence New Jersey 07974 (US)**
Inventor: **Lynch, William Thomas**
**72 Passaic Avenue**
**Summit New Jersey 07901 (US)**
Inventor: **Parrillo, Louis Carl**
**13 Christy Drive**
**Warren New Jersey 07060 (US)**

(74) Representative: **Watts, Christopher Malcolm Kelway et al**
**AT&T (UK) LTD. AT&T Intellectual Property Division 5 Mornington Road**
**Woodford Green Essex IG8 OTU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

### Background of the invention

The invention pertains generally to semiconductor devices and, particularly, to integrated circuits containing complementary metal oxide semiconductor devices.

Complementary metal oxide semiconductor (CMOS) integrated circuit devices include both n- and p-channel field effect transistors (FETs) on the same substrate. While, as known, it is generally desirable to space the different transistors as closely together as possible on the substrate, a limitation in the past is that if adjacent different type transistors (e.g., p and n channel field effect transistors) are too close together they can improperly electrically interact or "latchup" owing to the flow of leakage currents therebetween. One known solution is the use of dielectric material filled trenches extending into the substrate between adjacent transistors. One problem, however, is that semiconductor substrates containing such trenches have, in the past, been excessively susceptible to cracking. Also, to obtain adequate isolation between the adjacent transistors, relatively deep trenches have been required. The deeper the trenches, however, the longer and more costly the fabrication process and the more likely are the substrates to crack.

In EP—A—0135354, which forms part of the state of the art only by virtue of Art 54(3) EPC and designates DE, FR, GB, IT and NL, there is described a CMOS integrated circuit in which complementary transistors are isolated by a trench with a polycrystalline silicon filling. The trench is formed by reactive ion etching and one of the properties of this process is stated to be that the opposite sides of the trench are substantially vertical, but with a slight outward slope, so that when the trench is filled no air spaces are formed.

### Summary of the invention

In the invention as claimed the trenches are formed with an outward slope between 5 and 10 degrees to the vertical. We have discovered that with a slope of less than 5 degrees some voids (air spaces) are still formed and that these can cause cracking during subsequent high-temperature processing.

### Brief description of the drawing

Fig. 1 is a cross-sectional view of a first embodiment of the inventive CMOS device; and

Figs. 2—3 are cross-sectional views of second and third embodiments of the inventive CMOS device.

### Detailed description

The invention is described in connection with an integrated circuit comprising a plurality of field-effect transistors disposed within a substrate of silicon. With a silicon substrate, the trench filler material preferably comprises polycrystalline or amorphous silicon ("polysilicon" hereinafter) because such material can be readily deposited to completely fill a trench of proper design and because its coefficient of thermal expansion is the same as that of the silicon substrate. Both these conditions—complete, void-free filling and matching coefficient of expansion—are essential to avoid the prior art problem of excessive cracking of the trench-containing substrates.

Other substrate-filler material combinations can be used. For example, it is possible to fill trenches in substrates of gallium arsenide with polycrystalline gallium arsenide deposited in known manner.

In general, provided the filler material adequately adheres to the trench walls, filler materials can be used with non-identical substrate materials provided the coefficients of thermal expansion of the materials match within a factor of about 3.

Thus, for example, because of its ease of deposition, and because of an adequate matching of coefficients of thermal expansion, polysilicon is a good candidate for use as a filler material in substrates of gallium arsenide and similar III—IV compounds.

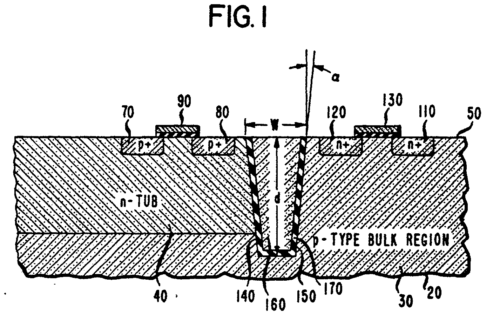

A first embodiment of the inventive device, depicted in Fig. 1, includes a substrate 20, of silicon, having a bulk region 30 of, for example, p-type conductivity (n-type conductivity is also useful) provided by a doping level ranging from about $10^{15}$ cm$^{-3}$ to about $10^{17}$ cm$^{-3}$. Doping levels less than about $10^{15}$ cm$^{-3}$ are undesirable because they require undesirably deep trenches to significantly reduce the possibility of latchup.

The substrate 20 also includes a tub 40 of conductivity type opposite to that of the bulk region 30, e.g., n-type conductivity, extending from the surface 50. The depth of the tub 40 is preferably greater than about 1/2 μm, while the vertical integrated doping level of the tub 40, i.e., the integral of the doping level of the tub 40 over the depth of the tub 40, ranges from about $10^{12}$ to about $10^{15}$ cm$^{-2}$, and is preferably about $10^{13}$ cm$^{-2}$. A depth less than about 1/2 μm, and/or a vertical integrated doping level less than about $10^{12}$ cm$^{-2}$, often result in undesirable punchthrough from the source (of an FET formed in the tub 40) to the bulk region 30.

The device includes a trench 140 which prevents, or substantially reduces the possibility of, latchup. The trench is formed in the silicon substrate 20, and separates the one or more p-channel FETs formed in the tub 40 from the one or more n-channel FETs fabricated in the bulk region 30, i.e., the trench encircles the FETs in the tub 40. Preferably, the trench 140 is formed after the fabrication of the tub 40 but before the fabrication of the FETs, and is preferably positioned at the juncture of the tub 40 and bulk region 30.

As previously noted, it is essential to completely fill the trench to avoid cracks which can develop during subsequent high temperature processing. A preferred filler material 160 is polysilicon which is readily deposited into the trench 140 using, for example, known conventional chemical vapor deposition (CVD) techniques.

In accordance with this invention, to avoid cracks and/or voids in the polysilicon, two conditions are met. The first is that the angle (denoted α in Fig. 1) between the trench sidewall 150 and a perpendicular to the substrate surface 50 is between about 5 to 10 degrees. It is found that trenches having steeper (e.g., vertical) walls or, worse, negative angle walls (e.g., trenches which widen towards the bottom) are quite difficult to completely fill. The diverging trench walls avoid any masking effects, by the walls, of the filler material during the deposition process. Conversely, trenches having wall angles in excess of 10 degrees become too wide, thus defeating the object of small transistor spacings.

The second condition is that the thickness of the polysilicon deposited in the trench filling process is adequate to at least completely fill the trench. To ensure this result, a thickness which is slightly excessive is used, and the excessive material overlying the trench is slightly etched back using known processes.

To prevent conduction of leakage currents, and diffusion of dopant, from the substrate 20 into the polysilicon 160, the trench 140 preferably includes a relatively thin layer of a dielectric material (material whose bandgap is greater than about 2 eV) 170 covering the interior surfaces of the trench. Useful dielectric materials include $SiO_2$ and $Si_3N_4$ deposited in known fashion. The thickness of the dielectric layer 170 (if employed) ranges from about 20 nm to about 500 nm. A thickness less than about 20 nm is undesirable as being ineffective to prevent short circuits through the polysilicon. A thickness greater than about 500 nm is undesirable as resulting in the formation of cracks and dislocations at the coating 170-trench wall 150 interface during high temperature processing.

Techniques for forming the trenches, e.g., by known masking and etching procedures, can be used. Preferably, the etching of the substrate to form the trenches is done by a known reactive-ion-etching process. As generally known, by controlling the etch rate of the process, the angle of slope of the trench walls can be selected.

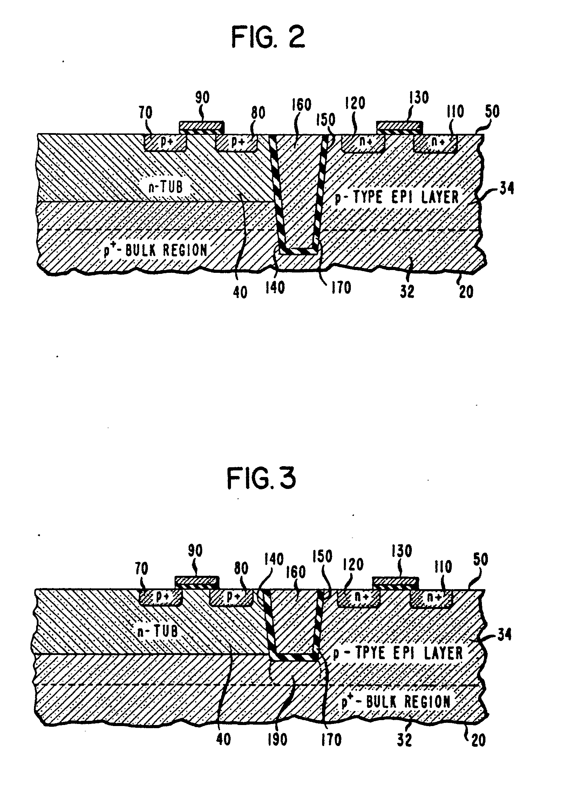

With reference to Fig. 2, a second embodiment of the inventive device differs from the first embodiment in that the substrate 20 includes a relatively heavily doped bulk region 32 of, for example, p-type conductivity, supporting a moderately doped, relatively thin (compared to the bulk region 32) layer 34 whose conductivity type is the same as that of the region 32. The layer 34 is preferably epitaxially grown on the bulk region 32 using, for example, conventional vapor phase epitaxy. A tub 40 of, for example, n-type conductivity, is formed in the moderately doped layer 34 and a trench 140 extends through the thickness of the layer 34 at least to the heavily doped bulk region 32. The advantage of this arrangement is that the depth of the trench 140 is reduced (as compared to the trench employed in the first embodiment) because the heavy doping within the bulk region 32 reduces the lifetime of minority charge carriers therethrough which would otherwise cause latchup between the two MOS devices shown.

The doping level within the bulk region 32 ranges from about $10^{17}$ to about $10^{21}$ cm$^{-3}$, and is preferably about $10^{20}$ cm$^{-3}$. A doping level less than about $10^{17}$ cm$^{-3}$ is undesirable because so low a doping level does not significantly reduce the possibility of latchup. A doping level greater than about $10^{21}$ cm$^{-3}$ is undesirable because so high a doping level results in an undesirably large out-diffusion of dopant from the bulk region 32 into the layer 34.

The layer 43 has a thickness ranging from about 1 μm to about 10 μm, and a doping level ranging from about $10^{14}$ to about $10^{17}$ cm$^{-3}$.

The tub 40 has a thickness greater than about 1/2 μm but less than the thickness of the layer 34, and a vertical integrated doping level ranging from about $10^{12}$ to about $10^{15}$ cm$^{-2}$.

With reference to Figure 3, a third embodiment of the inventive device is generally similar to the second embodiment except that the depth of the trench 140 is reduced by the depth of a relatively heavily doped region 190 within the layer 34, extending from the bottom of the trench into the bulk region 32. The conductivity type and the doping level range for the region 190 is the same as that for the bulk region 32, and thus the region 190 is essentially an extension of the bulk region 32 into the layer 34. The region 190 serves the same purpose as the bulk region 32, i.e., it reduces the lifetime of minority carriers therethrough (while decreasing trench depth).

The region 190 is formed by implanting donor or acceptor ions (depending on whether the region 190 is to be of $n^+$- or $p^+$-type conductivity) into the semiconductor material adjacent the bottom of the trench, and then diffusing these ions toward the bulk region 32 with a heat treatment. Because ions diffuse both vertically and laterally, vertical diffusion, and thus the depth of region 190, is preferably less than about 4 μm to avoid undesirable lateral diffusion of dopant into the tub 40.

Ion implantation preferably occurs after the formation of the dielectric layer 170 on the walls of the trench 140 (and before the deposition of the polysilicon). Because the trench sidewall 150 is inclined to the vertical (as viewed in Fig. 4), and because the ions travel an essentially vertical path, the ions impinging the sidewall of the trench must penetrate a greater thickness of dielectric material than the ions impinging the bottom of the trench to reach the underlying semiconductor material. Thus, relatively few, if any, ions penetrate the sidewall 150 into the tub 40.

If, for example, acceptor ions, such as boron ions, are used to dope the region 190, then useful dopant implantation levels (dopant per unit area) range from about $10^{14}$ to about $10^{17}$ cm$^{-2}$. An implantation level less than about $10^{14}$ cm$^{-2}$ is undesirable because this results in an undesirably low dopant concentration (dopant per unit volume) in the region 190. An implantation level greater than about $10^{17}$ cm$^{-2}$ is undesirable

because so great an implantation level is more than is required to achieve the desired dopant concentration, and requires an undesirably long time to achieve.

**Claims**

1. A semiconductor integrated device comprising: a semiconductor substrate (20) which includes first (30) and second (40) regions extending from a surface (50) of said substrate, the conductivity type of the second region being opposite to that of the first region; said first and second regions including, respectively, first (130) and second (90) field effect transistors, the channel conductivity type of said first transistor and of said second transistor being opposite, respectively, to the conductivity type of said first region and of said second region, and a trench (140) containing a filler material (160) extending from said surface into said substrate between said first and second regions to provide isolation between the said transistors, the coefficients of thermal expansion of the filler material and the substrate matching to within a factor of three, the side walls of said trench diverging in a direction upwards from the trench bottom the angle of said walls from the vertical being between 5 degrees and 10 degrees for substantially the whole of their vertical extent, and said filler material completely filling said trench and being essentially free of voids.

2. The device of claim 1 wherein said semiconductor substrate is of silicon and said filler material is of polysilicon.

3. The device of claim 1 in which both said first and second regions overlie a third region (Fig. 3, 32) of said substrate more heavily doped than said first and second regions and wherein, either said trench extends into said third region or said device further comprises a relatively heavily doped region (190) of the same conductivity type as said third region and extending from the bottom of said trench to said third region.

**Patentansprüche**

1. Integriertes Halbleiterbauteil mit einem Halbleitersubstrat (20), enthaltend
erste (30) und zweite (40) Zonen, die sich von einer Fläche (50) des Substrates aus erstrecken, wobei der Leitungstyp der zweiten Zone gegenüber dem der ersten Zone entgegengesetzt ist, wobei die ersten und zweiten Zonen erste (130) bzw. zweite (90) Feldeffekttransistoren aufweisen und wobei der Kanalleitungstyp des ersten Transistors und der des zweiten Transistors je gegenüber dem Leitungstyp der ersten Zone bzw. dem der zweiten Zone entgegengesetzt sind, und
einen ein Füllmaterial (160) enthaltenden Graben (140), der sich von der Fläche aus in das Substrat zwischen die ersten und zweiten Zonen erstreckt, um für eine Entkopplung zwischen den Transistoren zu sorgen, wobei der thermische Ausdehnungskoeffizient des Füllmaterials und der des Substrates auf innerhalb eines Faktors 3 aneinander angepaßt sind, die Seitenwände des Grabens vom Grabenboden aus in Richtung nach oben divergieren, der Winkel der Wände gegenüber der Vertikalen zwischen 5° und 10° für im wesentlichen deren gesamter vertikaler Ausdehnung beträgt und das Füllmaterial den Graben vollständig ausfüllt und im wesentlichen lückenfrei ist.

2. Bauteil nach Anspruch 1, bei dem das Halbleitersubstrat Silicium und das Füllmaterial Polysilicium ist.

3. Bauteil nach Anspruch 1, bei dem sowohl die ersten als auch die zweiten Zonen über einer dritten Zone (Fig. 3, 32) des Substrates, die stärker als die ersten und zweiten Zonen dotiert ist, liegen und bei dem entweder sich der Graben in die dritte Zone erstreckt oder das Bauteil des weiteren eine relativ stark dotierte Zone (190) des selben Leitungstyps wie die dritte Zone umfaßt, wobei sich jene Zone vom Grabenboden aus zur dritten Zone erstreckt.

**Revendications**

1. Un dispositif intégré à semiconducteur comprenant: un substrat semiconducteur (20) qui comprend des première (30) et seconde (40) régions s'étendant à partir d'une surface (50) de ce substrat, le type de conductivité de la seconde région étant opposé à celui de la première région; les première et seconde régions comprenant, respectivement, des premier (130) et second (90) transistors à effet de champ, le type de conductivité de canal du premier transistor et du second transistor étant respectivement opposé au type de conductivité de la première région et de la seconde région, et une tranchée (140) contenant une matière de remplissage (160), qui s'étend à partir de la surface et pénètre dans le substrat entre les première et seconde régions, pour établir une isolation entre les transistors, les coefficients de dilatation thermique de la matière de remplissage et du substrat concordant à un facteur de trois près, les parois latérales de la tranchée divergeant lorsqu'on s'élève à partir du fond de la tranchée, l'angle de ces parois par rapport à la verticale étant compris entre 5 degrés et 10 degrés sur la quasi-totalité de leur étendue verticale, et la matière de remplissage emplissant complètement la tranchée et étant pratiquement exempte de vides.

2. Le dispositif de la revendication 1, dans lequel le substrat semiconducteur consiste en silicium et la matière de remplissage consiste en silicium polycristallin.

3. Le dispositif de la revendication 1, dans lequel les première et seconde régions recouvrent toutes deux une troisième région (figure 3, 32) du substrat, plus fortement dopée que les première et seconde régions, et dans lequel ou bien la tranchée s'étend dans la troisième région, ou bien le dispositif comprend en outre une région relativement fortement dopée (190), qui présente le même type de conductivité que la troisième région et qui s'étend vers la troisième région à partir du fond de la tranchée.

# FIG. I

## FIG. 2

## FIG. 3